(19) Europäisches Patentamt
European Patent Office
Office européen des brevets

(11) **EP 3 301 467 B1**

(12) **EUROPÄISCHE PATENTSCHRIFT**

(45) Veröffentlichungstag und Bekanntmachung des Hinweises auf die Patenterteilung:
**03.11.2021 Patentblatt 2021/44**

(51) Int Cl.:
***G01R 33/30*** *(2006.01)*     ***G01R 33/31*** *(2006.01)*

(21) Anmeldenummer: **17189426.4**

(22) Anmeldetag: **05.09.2017**

(54) **VERBESSERTE TEMPERIERUNG EINES NMR-MAS-ROTORS**

IMPROVED REGULATION OF THE TEMPERATURE OF AN NMR-MAS ROTOR

TEMPÉRAGE AMÉLIORÉ D'UN ROTOR RMN MAS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.09.2016 DE 102016218772**

(43) Veröffentlichungstag der Anmeldung:
**04.04.2018 Patentblatt 2018/14**

(73) Patentinhaber: **Bruker BioSpin GmbH**
**76287 Rheinstetten (DE)**

(72) Erfinder:
- **Osen, David**
  **76275 Ettlingen (DE)**
- **Purea, Armin**
  **76669 Bad Schönborn (DE)**
- **Knott, Benno**
  **76189 Karlsruhe (DE)**
- **Kühler, Fabian**
  **8603 Schwerzenbach (CH)**
- **Helbing, Florian**
  **8037 Zürich (CH)**
- **Hassan, Alia**
  **8122 Binz (CH)**
- **Guidoulianov, Jevgeni**
  **8623 Wetzikon (CH)**
- **Freytag, Nicolas**
  **8122 Binz (CH)**

(74) Vertreter: **Kohler Schmid Möbus Patentanwälte Partnerschaftsgesellschaft mbB**
**Gropiusplatz 10**
**70563 Stuttgart (DE)**

(56) Entgegenhaltungen:
**US-B2- 7 915 893**

- **Venita Daebel: "Introduction to Proton Detection in Biological Samples under Ultra-Fast Magic Angle Spinning", Internet article , 2015, Seiten 1-6, XP055446320, Online Gefunden im Internet: URL:https://www.bruker.com/fileadmin/user_upload/2-Industries/Pharma_LifeSciences/Landing_Pages/Proton_Detection_AppNote_T1547 39.pdf [gefunden am 2018-01-31]**
- **AGUILAR-PARRILLA F ET AL: "TEMPERATURE GRADIENTS AND SAMPLE HEATING IN VARIABLE TEMPERATURE HIGH SPEED MAS NMR SPECTROSCOPY", JOURNAL OF MAGNETIC RESONANCE, ACADEMIC PRESS, ORLANDO, FL, US, Bd. 87, Nr. 3, Mai 1990 (1990-05), Seiten 592-597, XP000137832, ISSN: 1090-7807**
- **DIRK WILHELM ET AL: "Fluid flow dynamics in MAS systems", JOURNAL OF MAGNETIC RESONANCE., Bd. 257, 1. Juni 2015 (2015-06-01), Seiten 51-63, XP055446471, US ISSN: 1090-7807, DOI: 10.1016/j.jmr.2015.05.006**
- **JIRI BRUS: "Heating of samples induced by fast magic-angle spinning", SOLID STATE NUCLEAR MAGNETIC RESONANCE, Juni 2000 (2000-06), Seiten 151-160, XP055446671,**

EP 3 301 467 B1

**Beschreibung**

Die Erfindung betrifft ein Verfahren zum Betrieb eines NMR-Probenkopfes mit einem MAS-Stator zur Aufnahme eines im Wesentlichen kreiszylindrischen hohlen MAS-Rotors mit einem Außenmantel mit Außendurchmesser D und einer Probensubstanz in einem Probenvolumen, wobei der MAS-Rotor in einer Messposition innerhalb des MAS-Stators mittels einer Einrichtung zur Gaszufuhr mit einer Lagerdüse druckgasgelagert ist sowie mittels eines pneumatischen Antriebs in eine Rotation um die Zylinderachse des MAS-Rotors mit einer Rotationsfrequenz $f \geq 30\,kHz$ versetzt wird, wobei während der NMR-MAS-Messung mittels einer Temperierdüse ein Temperiergas unter einem Winkel $\alpha < 90°$ bezüglich der Längsachse des zylindersymmetrischen MAS-Rotors auf den Außenmantel des MAS-Rotors geblasen wird.

Ein solches Verfahren sowie ein entsprechender NMR-Probenkopf mit einem MAS-Stator und einem MAS-Rotor sind beispielsweise bekannt aus der US 7,915,893 B2.

Hintergrund der Erfindung

Die vorliegende Erfindung betrifft allgemein den Bereich der Magnetresonanz (MR). Kernspinresonanz(NMR)-Spektroskopie ist eine kommerziell weit verbreitete Methode der MR zur Charakterisierung der chemischen Zusammensetzung von Substanzen. Generell werden bei der MR Hochfrequenz(=HF)-Pulse in die Messprobe, die sich in einem starken statischen Magnetfeld befindet, eingestrahlt, und die elektromagnetische Reaktion der Probe wird vermessen.

Bei der Festkörper-NMR-Spektroskopie ist es weiter bekannt, zur Verringerung von Linienverbreiterungen aufgrund anisotroper Wechselwirkungen eine NMR-Probe während der spektroskopischen Vermessung unter dem so genannten "Magischen Winkel" von ca. 54,74° gegenüber dem statischen Magnetfeld verkippt rotieren zu lassen ("MAS" = Magic Angle Spinning). Dazu wird die Probe in einen MAS-Rotor gefüllt. MAS-Rotoren sind zylindrische Röhrchen, die mit einer oder zwei Kappen verschlossen sind, wobei die obere mit Flügelelementen («Schaufelrädchen») versehen ist. Der MAS-Rotor wird in einem MAS-Stator angeordnet, und mit Gasdruck wird der MAS-Rotor über die Flügelelemente für die Rotation angetrieben. Die Gesamtheit aus MAS-Rotor und MAS-Stator wird MAS-Turbine genannt.

Während der NMR-Messung ist die MAS-Turbine in einem NMR-MAS-Probenkopf angeordnet. Der Probenkopf verfügt über ein zylindrisches Abschirmrohr. Darin sind HF-Elektronikbauteile, insbesondere HF- Spulen, und die MAS-Turbine untergebracht. Der Probenkopf wird mit seinem Abschirmrohr typischerweise von unten in die vertikale Raumtemperatur-bohrung eines supraleitenden Magneten eingeführt, positioniert, und mit Haken, Stützen, Schrauben oder dergleichen gehalten. Die MAS-Turbine befindet sich dann genau im magnetischen Zentrum des Magneten.

Spezieller Stand der Technik

Bei der Rotation von Proben erwärmt sich die Rotorwand durch die Luftreibung. Der zentrale Bereich genau zwischen den Luftlagern erfährt dabei die stärkste Erwärmung. Dies führt zu

1. inhomogener Temperaturverteilung über der Probensubstanz und

2. unerwünschter Erwärmung der Probensubstanz, so dass eine niedrigere Zieltemperatur nicht eingestellt werden kann oder dass die Probe sogar thermisch zerstört wird.

Die Temperierung des Rotors erfolgt üblicherweise durch sogenannte VT-Kanäle bzw. Düsen, die ungefähr auf die Rotormitte gerichtet sind. Dabei wird entweder temperiertes Gas in die Radiallager eingestrahlt, gegebenenfalls von dort abgezweigt (sogenanntes VTN-Design) oder über einen separaten Kanal zugeführt, wobei die Lager dann bei einer von VT unabhängigen Temperatur, beispielsweise Raumtemperatur, betrieben werden (sogenannte DVT-Design).

Ein wesentliches Merkmal der Lösungen VTN und DVT liegt in der Ausführung der Temperierdüsen: Aufgrund der Positionierung und/oder der Größe der Temperierdüsen bringen diese das Gas so ein, dass die Gasgeschwindigkeit unmittelbar am Rotor deutlich geringer ist als die Umlaufgeschwindigkeit des Rotors, so dass der Kühlaufwand sehr hoch ist, um die Probe auch nur leicht unterhalb der Raumtemperatur zu temperieren (siehe unten die Vergleichstabelle).

Ein weiterer Nachteil besteht darin, dass sich in allen Fällen ein Temperaturgradient über die Länge des Rotors einstellt, der unerwünscht ist; d.h. in der Mitte des Rotors findet eine Erwärmung bis auf ca. 55°C bei einer Gesamtlänge von lediglich 6mm statt (siehe in der Zeichnung die Figur "Simulationsbericht").

Diese Temperierproblematik ist besonders ausgeprägt bei den kleinen Durchmessern $D \leq 1.9\,mm$.

Da die Temperaturregelung und insbesondere die Kühlung von MAS-Rotoren einen ganz erheblichen Aspekt für die Festkörperspektroskopie darstellt, gibt es verschiedene Strategien, diese zu verbessern.

In der US-A 5,289,130 wurde die Strategie beschrieben, das abströmende Antriebsgas für die Kühlung des Rotors zu benutzen. Dabei wird das Gas parallel zur Rotoroberfläche geführt und im Zentrum abgeführt. Bei dieser Gaszuführung ist davon auszugehen, dass die Gasgeschwindigkeit beim Auftreffen auf den Rotor bereits zu niedrig ist, um den Rotor signifikant zu kühlen. Ist die Gasgeschwindigkeit noch hoch genug, dann ist dies mit einem Effizienzverlust am Antrieb verbunden.

Eine -mit Ausnahme der Temperierdüsen- gattungsgemäße Anordnung mit den meisten der eingangs definierten Merkmale ist bereits bekannt durch Produkte der Bruker BioSpin GmbH, wie in dem Internet-Auftritt https://www.bruker.com/de/products/mr/nmr/probes/probes/solids/very-fast-mas/13-mm/overview.html sowie aus der Publikation von D. Wilhelm et al. "Fluid flow dynamics in MAS systems", Journal of Magnetic Resonance 257 (2015) 51-63 dargestellt.

Die ebenfalls eingangs zitierte US 7,915,893 B2 schließlich beschreibt eine vollständig gattungsgemäße Anordnung mit sämtlichen eingangs definierten Merkmalen. Zusätzlich wird eine VT-Düse gezeigt, die schräg auf den Rotor trifft. Das Dokument beschreibt einen kryogenen Probenkopf, bei welchem die Spulen auf kryogene Temperatur gebracht werden, während die Messprobe separiert temperiert wird. Daher ist hier eine räumliche Trennung von Elektronik und Rotor erforderlich. Der sogenannte Spinner (Rotor) befindet sich in einer nach außen abgeschlossenen Röhre und wird über eine Temperierdüse temperiert. Das temperierte Gas wird aus einer gemeinsamen Druckleitung auf die Lagerdüsen und die zusätzlichen Temperierdüsen verteilt.

Die US 7,915,893 B2 offenbart jedoch nicht, wie eine Temperierung in einem offenen System realisierbar ist, bei dem der Rotor sich nicht in einer engen Röhre befindet. Außerdem wird auch ein Zusammenhang der Effizienz der Rotortemperierung mit der Wahl der Anströmgeschwindigkeit nicht offenbart.

Ein erheblicher Nachteil sämtlicher bislang bekannten Temperiervorrichtungen für MAS-Rotoren ergibt sich im Betrieb bei hohen Drehzahlen der Rotoren während der Messung. Insbesondere bei Rotationsfrequenzen $f \geq 50kHz$ werden aufgrund der Luftreibung die Rotoren heiß, was zu ungewünschten Veränderungen oder gar zur Zerstörung der Messprobe führen kann.

### Aufgabe der Erfindung

Der vorliegenden Erfindung liegt demgegenüber die Aufgabe zugrunde, ein Verfahren der eingangs definierten Art sowie einen entsprechenden MAS-Stator für einen NMR-MAS-Probenkopf zur Verfügung zu stellen, mit welchen auch bei sehr schnell rotierenden MAS-Rotoren eine erheblich bessere Temperierung erreicht wird.

### Kurze Beschreibung der Erfindung

Diese Aufgabe wird gelöst durch ein Verfahren mit den eingangs definierten Merkmalen, das sich dadurch auszeichnet, dass die Strömungsgeschwindigkeit des durch die Temperierdüse auf den MAS-Rotor geblasenen Temperiergases im Düsenquerschnitt mindestens der halben Umfangsgeschwindigkeit des Außenmantels des rotierenden MAS-Rotors und höchstens der Schallgeschwindigkeit im Temperiergas entspricht, und dass die Temperierdüse einen Innendurchmesser d zwischen 0,04mm und 0,5mm aufweist und mit einem Druck von 0,1MPa bis 0,5MPa beaufschlagt wird.

Mit der vorliegenden Erfindung wird zudem auch ein entsprechend ausgestalteter und dimensionierter MAS-Stator für die NMR-MAS-Spektroskopie bereitgestellt, der eine wesentlich bessere Temperierung des MAS-Rotors auch bei höheren Rotationsfrequenzen erlaubt.

Im Unterschied zum oben diskutierten Stand der Technik versucht die vorliegende Erfindung, die Druckluft zur Kühlung des MAS-Rotors mit einer bestimmten Mindestgeschwindigkeit einzublasen, um damit einen signifikanten Austausch der Luftschichten an der Rotor-Oberfläche und dadurch eine verbesserte Kühlung zu bewirken.

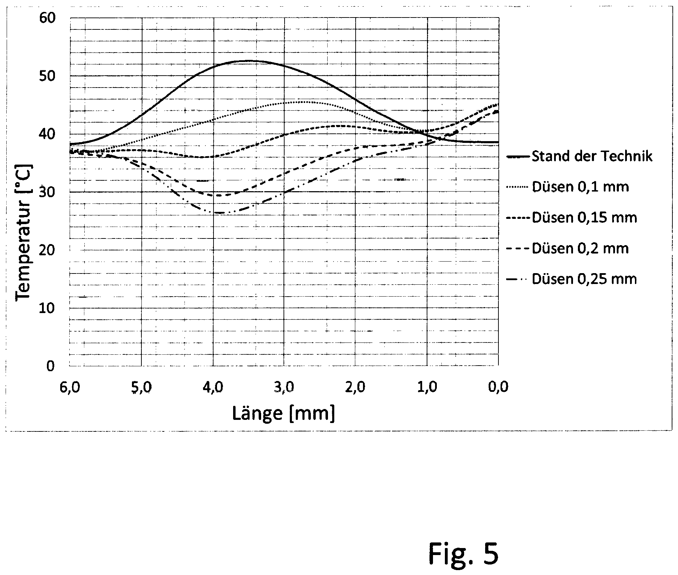

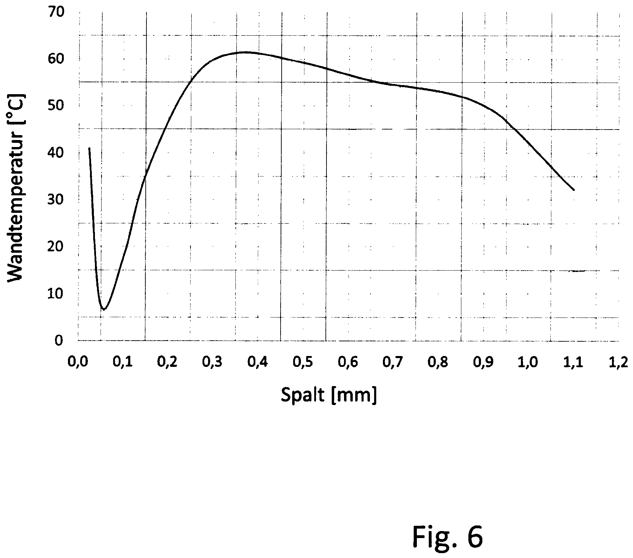

Kritisch für eine bessere Temperierbarkeit ist es offenbar, dass das Temperiergas mit einer im Vergleich zu den bisherigen Ansätzen höheren Geschwindigkeit an die Rotoroberfläche geblasen wird. Diese Geschwindigkeit liegt erfindungsgemäß in der Größenordnung der Umlaufgeschwindigkeit des Rotors, mindestens bei etwa der Hälfte davon. Dieses Ergebnis ist überraschend, da der relativ geringe Wärmeübertrag der herkömmlichen Temperierung (VTN, DVT) erst in den Simulationen sichtbar wurden, welche in den Figuren 5 und 6 dargestellt und unten im Einzelnen erläutert werden. Der bekannte Stand der Technik jedenfalls schweigt sich über die Effizienz der Kühlung aus. Theoretisch betrachtet hängt die übertragene Wärme auch von der Strömungsgeschwindigkeit ab. Offenbar bedarf es einer Mindestgeschwindigkeit des Temperiergases, sodass die Luftschichten nah am Rotor ausgetauscht werden, d.h. eine höhere Strömungsgeschwindigkeit führt zu mehr Wärmeübertragung am Rotor.

Zum Erreichen hoher Geschwindigkeiten sind daher erfindungsgemäß kleine Düsen vorgesehen, die bei Anlegen eines erhöhten Drucks einen schnellen Gasstrom entlang des Rotors in axialer Richtung erzeugen. Das führt zur Lehre der vorliegenden Erfindung, wonach die Geschwindigkeit des Gasstroms in der VT Düse mindestens 50% der Umlaufgeschwindigkeit des Rotors betragen sollte. Als Obergrenze gilt hierbei die Schallgeschwindigkeit, was auch die Obergrenze der Umlaufgeschwindigkeit des Rotors darstellt.

Ein weiterer Vorteil der vorliegenden Erfindung liegt darin, dass der vorhandene, marktübliche MAS-Stator kaum modifiziert werden muss und die Zusatzteile nur einen sehr geringen einen Materialaufwand erfordern, so dass die erfindungsgemäße Lehre äußerst kostengünstig verwirklicht werden kann.

Bevorzugte Varianten, Ausführungsformen und Weiterbildungen der Erfindung

Besonders bevorzugte Varianten der Erfindung zeichnen sich dadurch aus, dass der Außenmantel des MAS-Rotors einen Außendurchmesser $D \leq 1{,}9mm$ aufweist, und dass der MAS-Rotor mit einer Rotationsfrequenz $f \geq 50kHz$, vorzugsweise mit $f \geq 67kHz$, rotiert wird. Zwar spricht prinzipiell nichts dagegen, die Erfindung auch bei größeren Durchmessern einzusetzen, jedoch ist die Erwärmung und damit der Vorteil der Erfindung gerade bei kleineren Durchmessern des MAS-Rotors größer.

Bei weiteren vorteilhaften Varianten des erfindungsgemäßen Verfahrens beträgt der Normvolumenstrom des durch eine Temperierdüse geblasenen Temperiergases zwischen 0,01l/min und 10l/min. Ein zu geringer Gasfluss temperiert nämlich unzureichend, während ein zu hoher Fluss die Rotation negativ beeinflussen kann und daher gegebenenfalls auch unwirtschaftlich ist.

Physisch lässt sich das erfindungsgemäße Verfahren durchführen durch Einsatz eines MAS-Stators mit einer Temperiervorrichtung, die mindestens eine Temperierdüse zur Temperierung des MAS-Rotors sowie Mittel zur Beaufschlagung der Temperierdüse mit einem Druck umfasst, wobei sich der MAS-Stator dadurch auszeichnet, dass die mindestens eine Temperierdüse einen Innendurchmesser $d$ zwischen 0,04mm und 0,5mm aufweist, wobei die Mittel zur Beaufschlagung der Temperierdüse im Betrieb mit einem Druck dazu eingerichtet sind, die Temperierdüse mit einem Druck von 0,1MPa bis 0,5MPa (= 1bar bis 5bar) zu beaufschlagen.

Gerade mit dieser Merkmalskombination, nämlich durch den speziellen Düsendurchmesser und den angewandten Druck ergibt sich der oben diskutierte optimale Fluss entsprechend.

In den Rahmen der vorliegenden Erfindung fällt auch ein NMR-MAS Probenkopf mit einem MAS-Stator der oben beschriebenen erfindungsgemäßen Art, bei dem der Außenmantel des MAS-Rotors einen Außendurchmesser $D \leq 1{,}9mm$, insbesondere $0{,}7mm \leq D \leq 1{,}3mm$, aufweist, wobei der MAS-Rotor mit einer Rotationsfrequenz $f \geq 67kHz$ rotiert wird. Diese Ausführungsformen der Erfindung erweisen sich in der Praxis als besonders nützlich. Im Gegensatz dazu offenbart etwa der Stand der Technik nach der eingangs zitierten US 7,915,893 B2 Außendurchmesser $D$ des Rotors von etwa 3mm und reguläre Rotationsfrequenzen $f$ von etwa 30kHz.

Hierbei können zwei grundsätzlich unterschiedliche Statorvarianten zum Einsatz kommen, nämlich einerseits eine Raumtemperaturvariante, bei welcher der Stator offen ist und der Temperierstrom in die Umgebung entweichen kann, andererseits eine geschlossene Kryovariante mit gekühlter Sende-Empfangselektronik, bei welcher der Rotor in einer geschlossenen Röhre betrieben wird, sodass die Temperierströme nicht nach außen an die Kryo-Elektronik gelangen.

Bei einer ersten Klasse von vorteilhaften Ausführungsformen des erfindungsgemäßen NMR-MAS Probenkopfes ist also der MAS-Stator offen aufgebaut, so dass der Temperiergasstrom nach seinem Kontakt mit dem Außenmantel des MAS-Rotors in die Umgebung entweichen kann. Die Temperierdüse ist bei diesen Ausführungsformen derart angeordnet, dass ein Temperiergasstrom unter einem Winkel $\alpha < 45°$, vorzugsweise $\alpha < 30°$, relativ zur Längsachse des zylindersymmetrischen MAS-Rotors auf den Außenmantel des MAS-Rotors geblasen werden kann.

Da die Temperierdüse im Normalfall nicht genau an der Rotoroberfläche ansetzt, sollte die Einstrahlung des Temperiergases schräg auf den Rotor zielen. Außerdem gelangt ein derart schräg eingestrahlter Temperierfluss besser und effektiver in den Spalt zwischen dem Rotor und einer diesen umgebenden HF-Spule. Daher zielen die Düsen vom Radiallager ausgehend bevorzugt schräg in diesen Spalt. Dadurch ist es möglich, die Reibungswärme von der Rotoroberfläche effizienter abzuführen.

Der Gasstrom ist ausgehend vom oberen Lager nach unten gerichtet, und zwar bei einem Anströmwinkel von 0° bis 80°, vorzugsweise zwischen 20° und 40°. Ein weiterer Vorteil des Düsenanstellwinkels im Gegensatz zu herkömmlichen Pralldüsen liegt darin, dass der Rotor eine nach unten gerichtete Kraft erfährt, die ihm Haltestabilität gibt, was insbesondere bei kleinen Rotoren (also mit einem Außendurchmesser $D \leq 1{,}9mm$) wichtig ist.

In einer dazu alternativen Klasse von Ausführungsformen des erfindungsgemäßen NMR-MAS Probenkopfes ist der MAS-Stator geschlossen aufgebaut ist, so dass der Temperiergasstrom nach seinem Kontakt mit dem Außenmantel des MAS-Rotors nicht direkt in die Umgebung entweichen kann. Die Temperierdüse ist dann derart angeordnet, dass der Winkel $\alpha$ relativ zur Längsachse des zylindersymmetrischen MAS-Rotors $\alpha \leq 10°$ beträgt. Bei dieser Variante kann auch ein Gasstrom parallel zum Rotor geführt werden. Ein Zentralrohr erlaubt eine kontrolliertere Führung des Temperiergases.

Besonders bevorzugt sind Weiterbildungen dieser Klasse von Ausführungsformen, bei welchen zwischen dem Außenmantel des MAS-Rotors und der ihn umgebenden inneren Oberfläche des MAS-Stators ein Spalt mit einer Spaltbreite $b$ zwischen 0,02mm und 0,3mm für den Temperiergasstrom frei bleibt, damit ein ausreichender Austausch der Ströme in Rotornähe gewährleistet ist. Die Spaltbreite kann so eingestellt werden, dass die Temperierung verbessert wird, allerdings unter Umständen zu Lasten des notwendigen Drucks.

Vorteilhaft sind auch Weiterbildungen dieser Klasse von Ausführungsformen, bei denen die Temperierdüse derart angeordnet ist, dass ein Temperiergasstrom unter einem Winkel $\alpha \approx 0°$, also parallel zur Längsachse des zylindersymmetrischen MAS-Rotors am Außenmantel des MAS-Rotors entlang geblasen werden kann. Für den Fall, dass ein Zentralrohr vorhanden ist, muss nicht mehr unbedingt schräg eingestrahlt werden, da das Rohr selbst für die nötige Führung sorgt.

Bei anderen bevorzugten Weiterbildungen der Erfindung ist der MAS-Rotor von einer solenoidförmigen HF-Spule umgeben, welche entweder frei tragend ausgeführt oder auf der Außenfläche eines Rohres aufgewickelt und derart angeordnet ist, dass der Temperiergasstrom zwischen dem Rotor und dem Rohr bzw. der Spule geführt werden kann. Die HF-Spule ist ein notwendiger Bestandteil für NMR-Messungen. Zusammen mit einem Trägerrohr sorgt sie hier auch für die Führung des Temperiergases.

Diese Weiterbildungen können noch dadurch verbessert werden, dass der MAS-Rotor in einem Abstand zwischen 0,02mm und 0,3mm von der Innenwand des Trägerrohres mit der solenoidförmigen HF-Spule umgeben ist. Auch hier kann wiederum die Spaltbreite so eingestellt werden, dass die Temperierung des MAS-Rotors verbessert wird.

Vorteilhaft sind auch Ausführungsformen des erfindungsgemäßen NMR-MAS-Probenkopfes, die sich dadurch auszeichnen, dass mehrere, insbesondere untereinander identisch aufgebaute, Temperierdüsen vorhanden sind, die vorzugsweise symmetrisch um die Längsachse des zylindersymmetrischen MAS-Rotors angeordnet sind. Eine derartige radiale Symmetrie vermeidet mechanische Beeinflussung der Rotors in eine bestimmte Richtung. Außerdem ermöglicht eine Vielzahl von Düsen einen höheren Temperiergasfluss.

Besonders bevorzugt sind auch Ausführungsformen des erfindungsgemäßen NMR-MAS-Probenkopfes, bei welchen die Temperierdüse(n) in einem Radiallager des MAS-Stators eingebaut ist (sind). Damit erhält man einen sehr kompakten Aufbau. Die gleichzeitige Beschickung des Lagers und der Temperierung durch eine einheitliche Gaszufuhr vereinfacht das MAS-System.

Alternativ kann (können) bei einer anderen Ausführungsform des NMR-MAS-Probenkopfes die Temperierdüse(n) über einen separaten Kanal mit Temperiergas beschickt werden. In bestimmten Anwendungen (z.B. bei Tieftemperatur) kann es andererseits notwendig sein, den Temperierkanal räumlich und eventuell auch thermisch zu entkoppeln. Dadurch gewinnt man einen weiteren Freiheitsgrad, da der Temperierkanal dann unabhängig vom Lagerkanal mit beliebigem Druck und beliebiger Temperatur betrieben werden kann.

In der Praxis bewähren sich schließlich besonders Ausführungsformen des erfindungsgemäßen Probenkopfes, bei welchen der MAS-Rotor aus Saphir, tetragonal stabilisiertem Zirkonoxid und/oder Siliziumnitrid, mit einer Wanddicke zwischen 0,2mm bis 0,7mm, vorzugsweise etwa 0,3mm und 0,55mm, sowie mit einem Durchmesser kleiner 4mm, insbesondere etwa 3,2mm, etwa 1,9mm oder etwa 1,3mm, aufgebaut ist. Diese Materialien sind für MAS-NMR besonders geeignet, da sie unmagnetisch elektrisch nicht leitfähig sind, ausreichend mechanische Festigkeit besitzen, um den bei der Rotation auftretenden Kräften standzuhalten und man deren Wandstärke in oben genannter Weise auf maximale Transmission einstellen kann.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Die Erfindung ist in der Zeichnung dargestellt und wird anhand von Ausführungsbeispielen näher erläutert.
Es zeigen:

Fig. 1      eine schematische Querschnittsdarstellung einer Ausführungsform des erfindungsgemäßen NMR-MAS-Probenkopfs mit offenem MAS-Stator und schräg zur Achse auf den MAS-Rotor gerichteter Temperierdüse;

Fig. 2      eine schematische Querschnittsdarstellung eines NMR-MAS-Probenkopfs mit offenem MAS-Stator gemäß Stand der Technik (Bruker BioSpin GmbH);

Fig. 3a      eine schematische Querschnittsdarstellung einer offenen Ausführungsform des erfindungsgemäßen MAS-Stators mit schräg auf den MAS-Rotor gerichteten Temperierdüsen;

Fig. 3b      Ausführungsform wie Fig. 3a, jedoch mit parallel zur Längsachse des MAS-Rotors gerichteten Temperierdüsen;

Fig. 4a      eine schematische Querschnittsdarstellung einer geschlossenen Ausführungsform des erfindungsgemäßen MAS-Stators mit schräg auf den MAS-Rotor gerichteten Temperierdüsen;

Fig. 4b    Ausführungsform wie Fig. 4a, jedoch mit parallel zur Längsachse des MAS-Rotors gerichteten Temperierdüsen;

Fig. 5    eine Grafik mit berechneten Temperaturverläufen in der Mess-Probe längs der Rotorachse bei verschiedenen Durchmessern der Temperierdüse; und

Fig. 6    eine Grafik mit dem berechneten Verlauf der Wandtemperatur auf einem Punkt des MAS-Rotors in Abhängigkeit vom Spaltabstand zwischen dem Rotor und einem Zentralrohr bei einem geschlossenen MAS-Stator.

Die Erfindung in ihrer körperlichen Form betrifft eine neuartige Ausgestaltung eines MAS-Stators sowie eines NMR-MAS-Probenkopfes mit diesem MAS-Stator zur Durchführung des oben beschriebenen erfindungsgemäßen Verfahrens und findet ihre Hauptanwendung als Bestandteil einer Magnetresonanz-Apparatur.

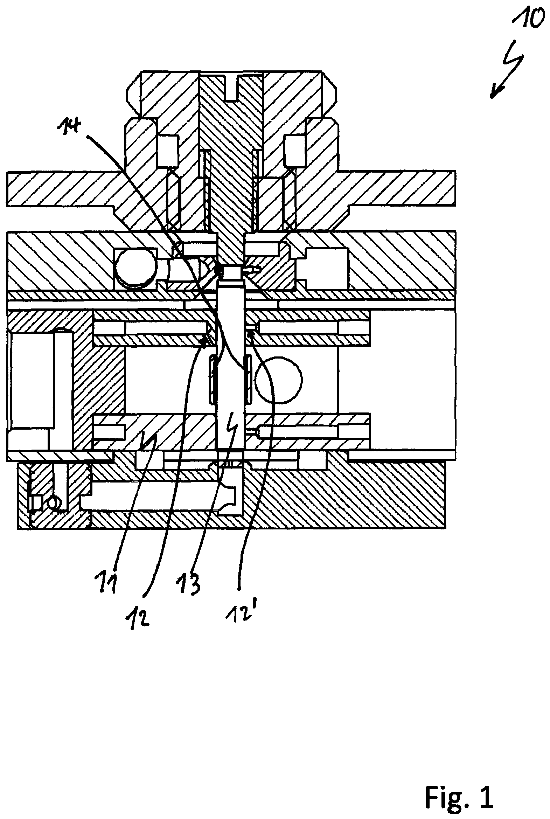

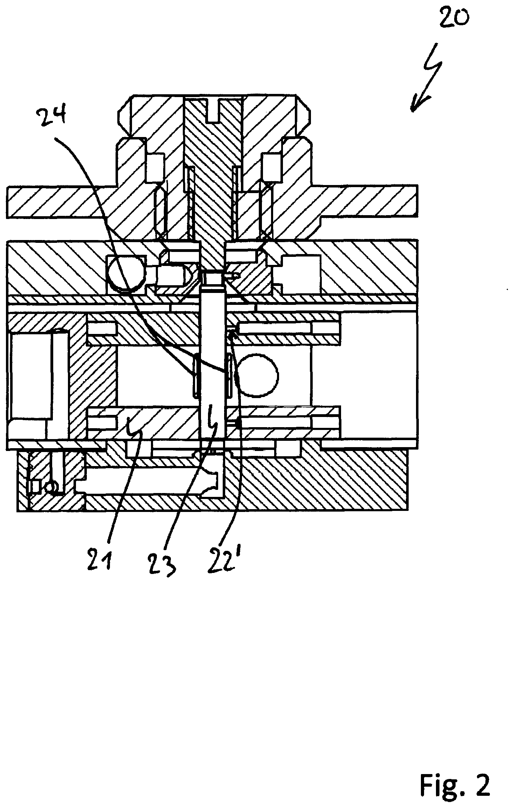

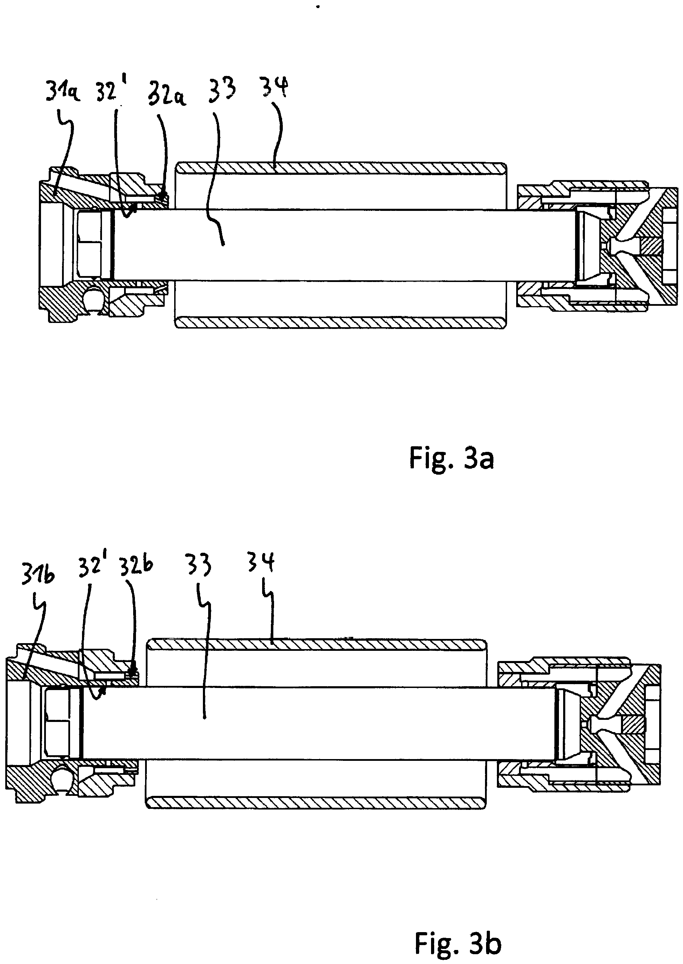

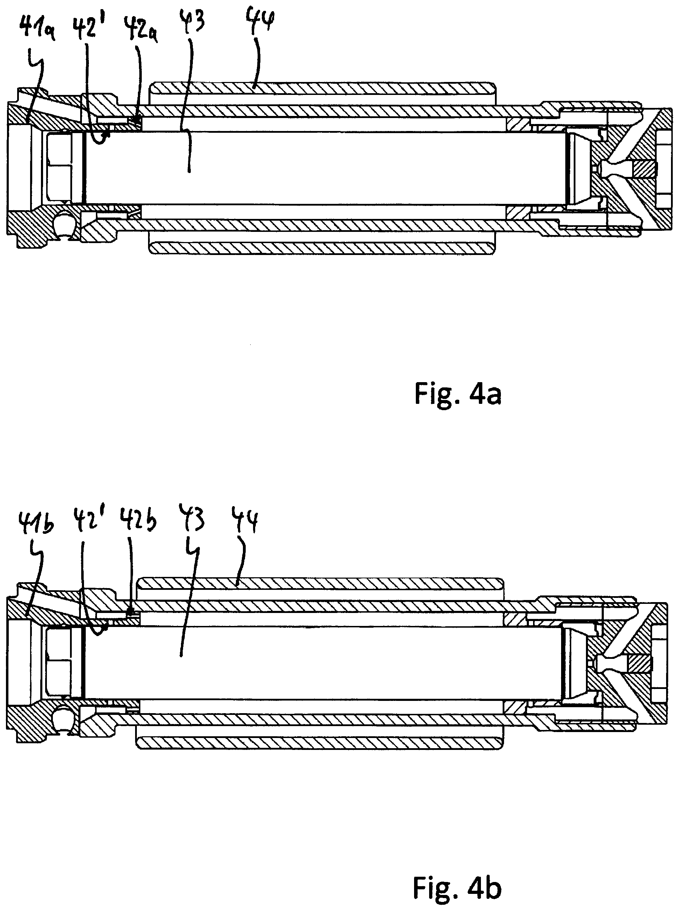

Sämtliche Ausführungsformen der erfindungsgemäßen Anordnung, wie sie in den Figuren 1, 3a bis 4b dargestellt sind -aber auch Anordnungen nach dem Stand der Technik, von denen eine in Fig. 2 gezeigt ist- umfassen jeweils einen **MAS-Stator 11; 21; 31a; 31b; 41a; 41b** eines **NMR-Probenkopfes 10; 20** zur Aufnahme eines im Wesentlichen kreiszylindrischen hohlen **MAS-Rotors 13; 23;** 33; **43** mit einem Außenmantel mit Außendurchmesser D, welcher eine Probensubstanz in einem Probenvolumen enthält und in einer Messposition innerhalb des MAS-Stators 11; 21; 31a; 31b; 41a; 41b mittels einer Einrichtung zur Gaszufuhr mit mindestens einer **Lagerdüse 12'; 22'; 32'; 42'** druckgasgelagert sowie mittels eines pneumatischen Antriebs in eine Rotation mit einer Rotationsfrequenz f um die Zylinderachse des MAS-Rotors 13; 23; 33; 43 versetzt werden kann. Der MAS-Rotor 13; 23; 33; 43 ist jeweils von einer solenoidförmigen **HF-Spule 14; 24; 34; 44** umgeben. Außerdem weisen sämtliche Ausführungsformen der Erfindung (sowie auch Anordnungen nach dem Stand der Technik) eine oder mehrere **Temperierdüse(n) 12; 32a; 32b; 42a; 42b** auf, durch welche während einer NMR-MAS-Messung ein Temperiergas auf den Außenmantel des MAS-Rotors 13; 33; 43 geblasen wird.

Die Erfindung zeichnet sich dadurch aus, dass die Strömungsgeschwindigkeit des durch die Temperierdüse 12; 32a; 32b; 42a; 42b auf den MAS-Rotor 13; 33; 43 geblasenen Temperiergases im Düsenquerschnitt mindestens der halben Umfangsgeschwindigkeit des Außenmantels des rotierenden MAS-Rotors 13; 33; 43 und höchstens der Schallgeschwindigkeit im Temperiergas entspricht.

Im Stand der Technik wird ein temperierter Gasstrom in der Regel direkt mittels größerer Düsen senkrecht auf den Rotor gerichtet. Damit kann nur ein geringer Wärmeaustausch am Rotor erfolgen, sodass sich ein Wärmegradient zur Mitte des Rotors hin ausbildet.

Mit den erfindungsgemäß eingesetzten Temperierdüsen -und vor allem bei Anwendung des erfindungsgemäßen Verfahrens- wird hingegen der Luftstrom vorzugsweise zwischen Spule und Rotor mittels einer angewinkelten Düse und mit ausreichend hoher Geschwindigkeit eingeblasen. Bei den gezeigten Ausführungsbeispielen der Erfindung ist jeweils die Temperierströmung mit den Lagerdüsen verbunden, und die Temperierdüse hat einen kleineren Durchmesser als die Lagerdüse, damit hohe Strömungsgeschwindigkeiten erzielt werden. Die Hauptströmung im Spalt zwischen Rotor und Spule verläuft ebenfalls dort und sorgt für eine effiziente Kühlung.

Je nach Dimensionierung der Düsen und je nach Lager-/Temperierdruck kann die Erwärmung reduziert werden, und in gewissem Rahmen auch die Temperaturverteilung homogenisiert werden. Aus den Simulationsgrafiken geht hervor, dass bei Vergrößerung der Düsen und der damit verbundenen Erhöhung des Gasflusses auch die Kühlleistung steigt. Jedoch kann es gleichermaßen vorteilhaft sein, einen Fluss bzw. einen Düsengröße zu wählen, die einen niedrigen Temperaturgradienten ermöglicht. Die Erfindung ermöglicht in jedem Fall eine Kontrolle über die Art der Optimierung.

- MAS-Stator mit schrägen oder axialen Temperierdüsen in einem Winkel 0°-80° zur Rotorachse, der Rotormitte zugewendet sind und einen Gasstrom mit einer Geschwindigkeit von mind. 50% der Umlaufgeschwindigkeit aufbringen.
- Temperierdüsen sind im Radiallager eingebracht, somit kann eine Zuleitung wegfallen
- Düsen-0 0,04mm bis 0,5mm
- Temperierdüsen, die in derselben Weise positioniert sind, aber über einen separaten Kanal mit Gas beschickt werden (Vorteil: die Doppelfunktion des Lagerkanals, Luftlagern des Rotors und Temperieren wird entkoppelt, der Lagerkanal kann bei konstanter Temperatur betrieben werden)

Die HF-Spule ist meist auf ein Rohr gewickelt, so dass der axiale Temperierstrom entlang des Rotors geführt wird. Eine Führung des VT-Stroms zusammen mit einem definierten Spalt zwischen Rotor und Zentralrohr kann eine weitere VT-Optimierung bringen. Denkbar sind auch Zentralrohr-Varianten. Das erfindungsgemäße MAS Rotor-Stator System ist für Rotorgrößen mit Außendurchmessern D ≤ 1,9mm ausgelegt. Gerade bei diesen kleineren Rotoren ist die Reibungswärme recht groß und das System ist schwierig temperierbar. Vermutlich liegt dies auch an der geringeren Masse sowie an der geringeren Oberfläche der kleineren Rotoren im Verhältnis zur entstehenden Reibleistung.

Strömung durch die Temperierdüsen

Für den Massenstrom $\dot{m}$ eines idealen Gases mit Adiabatenexponent $\kappa$, das aus einem Kessel mit Druck $p_0$, Dichte $\rho_0$, Temperatur $T_0$ durch eine Düse mit Querschnittsfläche $A_1$ ausströmt, gilt:

$$\dot{m} = A_1 \sqrt{\frac{2\kappa}{\kappa-1} p_0 \varrho_0} \cdot \sqrt{\left(\frac{p_1}{p_0}\right)^{2/\kappa} - \left(\frac{p_1}{p_0}\right)^{(\kappa+1)/\kappa}}$$

$p_1$ entspricht dem Außendruck. Die Dichte des Gases $\rho_0$ hängt für ein ideales Gas wie folgt mit dem Druck $p_0$ im Kessel zusammen:

$$\varrho_0 = \frac{p_0}{R_S T}$$

$R_s$ ist dabei die spezifische Gaskonstante des betreffenden Gases.

Der Massenstrom $\dot{m}$ hat die Einheit $\frac{kg}{s}$ und lässt sich wie folgt in den Normvolumenstrom umrechnen:

$$\dot{V}_n = \frac{\dot{m}}{\varrho} = \frac{R_S T_n}{p_n} \dot{m}$$

Dabei ist $p_n$ = 1013 *mbar* und $T_n$ = 273 K (Druck und Temperatur bei Normbedingungen).
Die Austrittsgeschwindigkeit aus der Düse errechnet sich wie folgt:

$$v_1 = \frac{\dot{m}}{\varrho_1 A_1} = \sqrt{\frac{2\kappa}{\kappa-1} \frac{p_0}{\varrho_0} \left[1 - \left(\frac{p_1}{p_0}\right)^{(\kappa-1)/\kappa}\right]}$$

In Fig. 5 bedeuten die durchgezogene Linie den Stand der Technik (wie derzeit von Bruker BioSpin GmbH angeboten), die gestrichelten Linien die Erfindung mit unterschiedlichen Düsen. Bei dieser vergleichenden Grafik wird verdeutlicht, dass mittels der Temperierdüsen die Maximaltemperatur sowie z.T. auch der Temperaturgradient am Rotor verringert wird. Es zeigt sich auch, dass nicht nur die Luftgeschwindigkeit einen Einfluss auf die Rotortemperatur hat, sondern auch die Flussmenge. Je größer die Temperierdüse ist, desto stärker ist auch der Kühlungseffekt am Rotor.
Fig. 6 schließlich veranschaulicht den Verlauf der Temperatur auf einem Punkt des Rotors in Abhängigkeit vom Spaltabstand zwischen Rotor und Zentralrohr. Bei dieser Grafik sieht man, dass die Temperatur auf der Rotoroberfläche ausgehen von einem großen Spalt zunächst ansteigt, wenn der Spalt reduziert wird. Bei etwa 0,35mm Spalt wird ein Maximum erreicht. Reduziert man den Spalt weiter, so verbessert sich die Kühlleistung bis zu einem Optimum bei ca. 0,06mm, darunter steigt die Temperatur wieder stark an. Dazu muss jedoch berücksichtig werden, dass ein geringerer Spalt einen höheren Druck erfordert, so dass das apparative Optimum unter Umständen nicht bei 0,06mm liegt, sondern eher bei 0,1mm.

**Bezugszeichenliste**

| | |
|---|---|
| 10; 20 | NMR-Probenkopf |
| 11; 21; 31a; 31b; 41a; 41b | MAS-Stator |
| 12'; 22'; 32'; 42' | Lagerdüse(n) |
| 12; 32a; 32b; 42a; 42b | Temperierdüse(n) |
| 13; 23; 33; 43' | MAS-Rotor |

| 14; 24; 34; 44 | HF-Spule |
|---|---|

## Patentansprüche

**1.** Verfahren zum Betrieb eines NMR-Probenkopfes (10; 20) mit einem MAS-Stator (11; 21; 31a; 31b; 41a; 41b) zur Aufnahme eines im Wesentlichen kreiszylindrischen hohlen MAS-Rotors (13; 23; 33; 43) mit einem Außenmantel mit Außendurchmesser D und einer Probensubstanz in einem Probenvolumen, wobei der MAS-Rotor (13; 23; 33; 43) in einer Messposition innerhalb des MAS-Stators (11; 21; 31a; 31b; 41a; 41b) mittels einer Einrichtung zur Gaszufuhr mit einer Lagerdüse (12; 22'; 32'; 42') druckgasgelagert ist sowie mittels eines pneumatischen Antriebs in eine Rotation um die Zylinderachse des MAS-Rotors (13; 23; 33; 43) mit einer Rotationsfrequenz f ≥ 30kHz versetzt wird, wobei während der NMR-MAS-Messung mittels einer Temperierdüse (12; 32a; 32b; 42a; 42b) ein Temperiergas unter einem Winkel α < 90° bezüglich der Längsachse des zylindersymmetrischen MAS-Rotors (13; 23; 33; 43) auf den Außenmantel des MAS-Rotors (13; 23; 33; 43) geblasen wird,
**dadurch gekennzeichnet,**

**dass** die Strömungsgeschwindigkeit des durch die Temperierdüse (12; 32a; 32b; 42a; 42b) auf den MAS-Rotor (13; 33; 43) geblasenen Temperiergases im Düsenquerschnitt mindestens der halben Umfangsgeschwindigkeit des Außenmantels des rotierenden MAS-Rotors (13; 33; 43) und höchstens der Schallgeschwindigkeit im Temperiergas entspricht,
und **dass** die Temperierdüse (12; 32a; 32b; 42a; 42b) einen Innendurchmesser d zwischen 0,04mm und 0,5mm aufweist und mit einem Druck von 0,1MPa bis 0,5MPa beaufschlagt wird.

**2.** Verfahren nach Anspruch 1, **dadurch gekennzeichnet, dass** der Außenmantel des MAS-Rotors (13; 33; 43) einen Außendurchmesser D ≤ 1,9mm aufweist, und dass der MAS-Rotor (13; 33; 43) mit einer Rotationsfrequenz f ≥ 50kHz, vorzugsweise f ≥ 67kHz, rotiert wird.

**3.** Verfahren nach Anspruch 1 oder 2, **dadurch gekennzeichnet, dass** der Normvolumenstrom des durch eine Temperierdüse (12; 32a; 32b; 42a; 42b) geblasenen Temperiergases zwischen 0,011/min und 10l/min beträgt.

**4.** MAS-Stator (11; 31a; 31b; 41a; 41b) zur Durchführung des Verfahren nach einem der vorhergehenden Ansprüche mit einer Temperiervorrichtung, welche mindestens eine Temperierdüse (12; 32a; 32b; 42a; 42b) zur Temperierung des MAS-Rotors (13; 33; 43) sowie Mittel zur Beaufschlagung der Temperierdüse (12; 32a; 32b; 42a; 42b) mit einem Druck umfasst, **dadurch gekennzeichnet, dass** die mindestens eine Temperierdüse (12; 32a; 32b; 42a; 42b) einen Innendurchmesser d zwischen 0,04mm und 0,5mm aufweist, und dass die Mittel zur Beaufschlagung der Temperierdüse (12; 32a; 32b; 42a; 42b) mit einem Druck dazu eingerichtet sind, die Temperierdüse (12; 32a; 32b; 42a; 42b) mit einem Druck von 0,1MPa bis 0,5MPa (= 1bar bis 5bar) zu beaufschlagen.

**5.** NMR-MAS-Probenkopf (10) mit einem MAS-Stator (11; 31a; 31b; 41a; 41b) nach Anspruch 4, **dadurch gekennzeichnet, dass** der Außenmantel des MAS-Rotors (13; 33; 43) einen Außendurchmesser D ≤ 1,9mm, insbesondere 0,7mm < D ≤ 1,3mm, aufweist, und dass der NMR-MAS-Probenkopf (10) Mittel umfasst, welche eingerichtet sind, den MAS-Rotor (13; 33; 43) mit einer Rotationsfrequenz f ≥ 67kHz zu rotieren.

**6.** NMR-MAS-Probenkopf nach Anspruch 5, **dadurch gekennzeichnet, dass** der MAS-Stator (11; 31a; 31b) offen aufgebaut ist, so dass der Temperiergasstrom nach seinem Kontakt mit dem Außenmantel des MAS-Rotors (13; 33) in die Umgebung entweichen kann, und dass die Temperierdüse (12; 32a; 32b) derart angeordnet ist, dass ein Temperiergasstrom unter einem Winkel α ≤ 45°, vorzugsweise α ≤ 30°, relativ zur Längsachse des zylindersymmetrischen MAS-Rotors (13; 33) auf den Außenmantel des MAS-Rotors (13; 33) geblasen werden kann.

**7.** NMR-MAS-Probenkopf nach Anspruch 5, **dadurch gekennzeichnet, dass** der MAS-Stator (41a; 41b) geschlossen aufgebaut ist, so dass der Temperiergasstrom nach seinem Kontakt mit dem Außenmantel des MAS-Rotors (43) nicht direkt in die Umgebung entweichen kann, und dass die Temperierdüse (42a; 42b) derart angeordnet ist, dass der Winkel α relativ zur Längsachse des zylindersymmetrischen MAS-Rotors (43) α ≤ 10° beträgt.

**8.** NMR-MAS-Probenkopf nach Anspruch 7, **dadurch gekennzeichnet, dass** zwischen dem Außenmantel des MAS-Rotors (43) und der ihn umgebenden inneren Oberfläche des MAS-Stators (41a; 41b) ein Spalt mit einer Spaltbreite b zwischen 0,02mm und 0,3mm für den Temperiergasstrom frei bleibt.

9. NMR-MAS-Probenkopf nach Anspruch 7 oder 8, **dadurch gekennzeichnet, dass** die Temperierdüse (42b) derart angeordnet ist, dass ein Temperiergasstrom unter einem Winkel $\alpha \approx 0°$, also parallel zur Längsachse des zylindersymmetrischen MAS-Rotors (43) am Außenmantel des MAS-Rotors (43) entlang geblasen werden kann.

10. NMR-MAS-Probenkopf nach einem der Ansprüche 5 bis 9, **dadurch gekennzeichnet, dass** der MAS-Rotor (13; 33; 43) von einer solenoidförmigen HF-Spule (14; 34; 44) umgeben ist, welche auf der Außenfläche eines Rohres aufgewickelt und derart angeordnet ist, dass der Temperiergasstrom zwischen dem Rotor und dem Rohr geführt werden kann.

11. NMR-MAS-Probenkopf nach Anspruch 10, **dadurch gekennzeichnet, dass** der MAS-Rotor (13; 33; 43) in einem Abstand zwischen 0,02mm und 0,3mm von der Innenwand des Rohres mit der solenoidförmigen HF-Spule (14; 34; 44) umgeben ist.

12. NMR-MAS-Probenkopf nach einem der Ansprüche 5 bis 11, **dadurch gekennzeichnet, dass** mehrere, insbesondere untereinander identisch aufgebaute, Temperierdüsen (12; 32a; 32b; 42a; 42b) vorhanden sind, die vorzugsweise symmetrisch um die Längsachse des zylindersymmetrischen MAS-Rotors (13; 33; 43) angeordnet sind.

13. NMR-MAS-Probenkopf nach einem der Ansprüche 5 bis 12, **dadurch gekennzeichnet, dass** die Temperierdüse(n) (12; 32a; 32b; 42a; 42b) in einem Radiallager des MAS-Stators (11; 31a; 31b; 41a; 41b) eingebaut ist (sind).

14. NMR-MAS-Probenkopf nach einem der Ansprüche 5 bis 11, **dadurch gekennzeichnet, dass** die Temperierdüse(n) (32a; 32b) über einen separaten Kanal mit Temperiergas beschickt werden kann (können).

15. NMR-MAS-Probenkopf nach einem der Ansprüche 5 bis 14, **dadurch gekennzeichnet, dass** der MAS-Rotor (13; 33; 43) aus Saphir, tetragonal stabilisiertem Zirkonoxid und/oder Siliziumnitrid, mit einer Wanddicke zwischen 0,2mm bis 0,7mm, vorzugsweise etwa 0,55mm, aufgebaut ist.

**Claims**

1. A method for operating an NMR probehead (10; 20) with an MAS stator (11; 21; 31a; 31b; 41a; 41b) for receiving a substantially circular-cylindrical hollow MAS rotor (13; 23; 33; 43) with an outer jacket of external diameter D and with a sample substance in a sample volume, wherein the MAS rotor (13; 23; 33; 43) is mounted on pressurized gas in a measuring position within the MAS stator (11; 21; 31a; 31b; 41a; 41b) by means of a device for gas supply with a bearing nozzle (12'; 22'; 32'; 42') and is set into rotation about the cylinder axis of the MAS rotor (13; 23; 33; 43) by means of a pneumatic drive, at a rotation frequency $f \geq 30$ kHz, wherein during the NMR-MAS measurement a temperature control gas is blown by means of a temperature control nozzle (12; 32a; 32b; 42a; 42b) onto the outer jacket of the MAS rotor (13; 23; 33; 43) at an angle $\alpha < 90°$ with respect to the longitudinal axis of the cylinder-symmetrical MAS rotor (13; 23; 33; 43),
**characterized in that**
the flow speed of the temperature control gas blown through the temperature control nozzle (12; 32a; 32b; 42a; 42b) onto the MAS rotor (13; 33; 43) corresponds in the nozzle cross section to at least half the circumferential speed of the outer jacket of the rotating MAS rotor (13; 33; 43) and to at most the speed of sound in the temperature control gas, and that the temperature control nozzle (12; 32a; 32b; 42a; 42b) has an inner diameter d of between 0.04mm and 0.5mm and a pressure of 0.1MPa to 0.5MPa is applied to the temperature control nozzle (12; 32a; 32b; 42a; 42b).

2. The method as claimed in claim 1, **characterized in that** the outer jacket of the MAS rotor (13; 33; 43) has an external diameter $D \leq 1.9$ mm, and the MAS rotor (13; 33; 43) is rotated at a rotation frequency $f \geq 50$ kHz, preferably $f \geq 67$ kHz.

3. The method as claimed in claim 1 or 2, **characterized in that** the standard volumetric flow of the temperature control gas blown through a temperature control nozzle (12; 32a; 32b; 42a; 42b) is between 0.01 l/min and 10 l/min.

4. An MAS stator (11; 31a; 31b; 41a; 41b) for carrying out the method as claimed in one of the preceding claims, with a temperature control device which comprises at least one temperature control nozzle (12; 32a; 32b; 42a; 42b) for controlling the temperature of the MAS rotor (13; 33; 43) and also comprises means for applying pressure to the temperature control nozzle (12; 32a; 32b; 42a; 42b), **characterized in that** the at least one temperature control nozzle (12; 32a; 32b; 42a; 42b) has an internal diameter d of between 0.04 mm and 0.5 mm, and that the means for applying pressure to the temperature control nozzle (12; 32a; 32b; 42a; 42b) are designed to apply a pressure of 0.1MPa to 0.5MPa (=1bar to 5bar) to the temperature control nozzle (12; 32a; 32b; 42a; 42b).

5. An NMR-MAS probehead (10) with an MAS stator (11; 31a; 31b; 41a; 41b) as claimed in claim 4, **characterized in that** the outer jacket of the MAS rotor (13; 33; 43) has an external diameter $D \leq 1.9$ mm, in particular $0.7$ mm $\leq D \leq 1.3$ mm, and that the NMR-MAS probehead (10) comprises means that are designed to rotate the MAS rotor (13; 33; 43) at a rotation frequency $f \geq 67$ kHz.

6. The NMR-MAS probehead as claimed in claim 5, **characterized in that** the MAS stator (11; 31a; 31b) has an open construction, such that the stream of temperature control gas can escape into the environment after its contact with the outer jacket of the MAS rotor (13; 33), and that the temperature control nozzle (12; 32a; 32b) is arranged in such a way that a stream of temperature control gas can be blown onto the outer jacket of the MAS rotor (13; 33) at an angle $\alpha \leq 45°$, preferably $\alpha \leq 30°$, relative to the longitudinal axis of the cylinder-symmetrical MAS rotor (13; 33).

7. The NMR-MAS probehead as claimed in claim 5, **characterized in that** the MAS stator (41a; 41b) has a closed construction, such that the stream of temperature control gas cannot escape directly into the environment after its contact with the outer jacket of the MAS rotor (43), and that the temperature control nozzle (42a; 42b) is arranged in such a way that the angle $\alpha$ relative to the longitudinal axis of the cylinder-symmetrical MAS rotor (43) is $\alpha \leq 10°$.

8. The NMR-MAS probehead as claimed in claim 7, **characterized in that** a gap with a gap width b of between 0.02 mm and 0.3 mm is left free for the stream of temperature control gas between the outer jacket of the MAS rotor (43) and the surrounding inner surface of the MAS stator (41a; 41b).

9. The NMR-MAS probehead according to claim 7 or 8, **characterized in that** the temperature control nozzle (42b) is arranged in such a way that a stream of temperature control gas can be blown along the outer jacket of the MAS rotor (43) at an angle $\alpha \approx 0°$, i.e. parallel to the longitudinal axis of the cylinder-symmetrical MAS rotor (43).

10. The NMR-MAS probehead as claimed in one of claims 5 to 9, **characterized in that** the MAS rotor (13; 33; 43) is surrounded by a solenoid-shaped RF coil (14; 34; 44) which is wound onto the outer face of a tube and is arranged in such a way that the stream of temperature control gas can be guided between the rotor and the tube.

11. The NMR-MAS probehead according to claim 10, **characterized in that** the MAS rotor (13; 33; 43) is surrounded by the solenoid-shaped RF coil (14; 34; 44) at a distance of between 0.02 mm and 0.3 mm from the inner wall of the tube.

12. The NMR-MAS probehead as claimed in one of claims 5 to 11, **characterized in that** several temperature control nozzles (12; 32a; 32b; 42a; 42b), in particular of identical configuration to each other, are present and are preferably arranged symmetrically about the longitudinal axis of the cylinder-symmetrical MAS rotor (13; 33; 43).

13. The NMR-MAS probehead as claimed in one of claims 5 to 12, **characterized in that** the temperature control nozzle(s) (12; 32a; 32b; 42a; 42b) is (are) built into a radial bearing of the MAS stator (11; 31a; 31b; 41a; 41b).

14. The NMR-MAS probehead as claimed in one of claims 5 to 11, **characterized in that** the temperature control nozzle(s) (32a; 32b) can be supplied with temperature control gas via a separate channel.

15. The NMR-MAS probehead as claimed in one of claims 5 to 14, **characterized in that** the MAS rotor (13; 33; 43) is constructed from sapphire, tetragonally stabilized zirconium oxide and/or silicon nitride, with a wall thickness of between 0.2 mm and 0.7 mm, preferably approximately 0.55 mm.

**Revendications**

1. Procédé d'actionnement d'une tête de sonde RMN (10; 20) équipée d'un stator RAM (11 ; 21 ; 31a ; 31b ; 41a ; 41b) conçu pour recevoir un rotor RAM (13 ; 23 ; 33 ; 43) creux, substantiellement cylindrique circulaire, présentant une enveloppe extérieure de diamètre extérieur D et une substance d'échantillonnage dans un volume d'échantillonnage, ledit rotor RAM (13 ; 23 ; 33 ; 43) étant supporté par du gaz sous pression en un emplacement de mesure, à l'intérieur dudit stator RAM (11 ; 21 ; 31a ; 31b ; 41a ; 41b), au moyen d'un dispositif d'arrivée de gaz doté d'un injecteur de palier (12' ; 22' ; 32' ; 42'), et étant animé d'une rotation autour de l'axe cylindrique dudit rotor RAM (13 ; 23 ; 33 ; 43) au moyen d'un entraînement pneumatique, avec une fréquence de rotation f ≥ 30 kHz, sachant que, durant la mesure RMN-RAM, un gaz d'équilibrage thermique est insufflé sur l'enveloppe extérieure du rotor RAM (13 ; 23 ; 33 ; 43) au moyen d'une buse (12 ; 32a ; 32b ; 42a ; 42b) d'équilibrage de température, selon un angle α < 90° par rapport à l'axe longitudinal dudit rotor RAM (13 ; 23 ; 33 ; 43) à symétrie cylindrique, **caractérisé par le fait**

**que** la vitesse d'écoulement du gaz d'équilibrage thermique insufflé sur le rotor RAM (13 ; 33 ; 43) par l'intermédiaire de la buse (12 ; 32a ; 32b ; 42a ; 42b) d'équilibrage de température correspond, dans la section transversale de ladite buse, au minimum à la moitié de la vitesse périphérique de l'enveloppe extérieure dudit rotor RAM (13 ; 33 ; 43) effectuant une rotation et, au maximum, à la vitesse du son dans ledit gaz d'équilibrage thermique ;
et par le fait que ladite buse (12 ; 32a ; 32b ; 42a ; 42b) d'équilibrage de température présente un diamètre intérieur d compris entre 0,04 mm et 0,5 mm, et est sollicitée par une pression de 0,1 MPa à 0,5 MPa.

2.  Procédé selon la revendication 1, **caractérisé par le fait que** l'enveloppe extérieure du rotor RAM (13 ; 33 ; 43) présente un diamètre extérieur D ≤ 1,9 mm ; et **par le fait que** ledit rotor RAM (13 ; 33 ; 43) est animé d'une rotation à une fréquence f ≥ 50 kHz, de préférence f ≥ 67 kHz.

3.  Procédé selon la revendication 1 ou 2, **caractérisé par le fait que** le débit volumique standard du gaz d'équilibrage thermique, insufflé par l'intermédiaire d'une buse (12 ; 32a ; 32b ; 42a ; 42b) d'équilibrage de température, se situe entre 0,01 L/min et 10 L/min.

4.  Stator RAM (11 ; 31a; 31b ; 41a; 41b) dévolu à la mise en œuvre du procédé conforme à l'une des revendications précédentes, muni d'un dispositif de régulation thermique incluant au moins une buse (12 ; 32a ; 32b ; 42a ; 42b) d'équilibrage de température, dédiée à l'équilibrage thermique du rotor RAM (13 ; 33 ; 43), ainsi que des moyens affectés à la sollicitation de ladite buse (12 ; 32a ; 32b ; 42a ; 42b) d'équilibrage de température par une pression, **caractérisé par le fait que** la buse (12 ; 32a ; 32b ; 42a ; 42b) d'équilibrage de température, à présence minimale, est pourvue d'un diamètre intérieur d compris entre 0,04 mm et 0,5 mm ; et **par le fait que** lesdits moyens, affectés à la sollicitation de ladite buse (12 ; 32a ; 32b ; 42a ; 42b) d'équilibrage de température par une pression, sont conçus pour solliciter ladite buse (12 ; 32a ; 32b ; 42a ; 42b) d'équilibrage de température par une pression de 0,1MPa à 0,5 MPa (= 1 bar à 5 bar).

5.  Tête de sonde RMN-RAM (10) dotée d'un stator RAM (11 ; 31a ; 31b ; 41a ; 41b) conforme à la revendication 4, **caractérisée par le fait que** l'enveloppe extérieure du rotor RAM (13 ; 33 ; 43) présente un diamètre extérieur D ≤ 1,9 mm, notamment 0,7 mm ≤ D ≤ 1,3 mm ; et **par le fait que** ladite tête de sonde RMN-RAM (10) inclut des moyens conçus pour imprimer, audit rotor RAM (13 ; 33 ; 43), une rotation à une fréquence f ≥ 67 kHz.

6.  Tête de sonde RMN-RAM selon la revendication 5, **caractérisée par le fait que** le stator RAM (11 ; 31a ; 31b) présente un agencement structurel ouvert, de telle sorte que le flux de gaz d'équilibrage thermique puisse s'échapper vers l'espace environnant après son contact avec l'enveloppe extérieure du rotor RAM (13 ; 33) ; et **par le fait que** la buse (12 ; 32a ; 32b) d'équilibrage de température est disposée de façon telle qu'un flux de gaz d'équilibrage thermique puisse être insufflé sur ladite enveloppe extérieure du rotor RAM (13 ; 33) selon un angle α ≤ 45°, de préférence α ≤ 30°, par rapport à l'axe longitudinal dudit rotor RAM (13 ; 33) à symétrie cylindrique.

7.  Tête de sonde RMN-RAM selon la revendication 5, **caractérisée par le fait que** le stator RAM (41a ; 41b) présente un agencement structurel fermé, de telle manière que le flux de gaz d'équilibrage thermique ne puisse pas s'échapper directement vers l'espace environnant après son contact avec l'enveloppe extérieure du rotor RAM (43) ; et **par le fait que** la buse (42a ; 42b) d'équilibrage de température est disposée de telle sorte que l'angle α, par rapport à l'axe longitudinal dudit rotor RAM (43) à symétrie cylindrique, soit α ≤ 10°.

8.  Tête de sonde RMN-RAM selon la revendication 7, **caractérisée par le fait qu'**un interstice présentant une largeur b comprise entre 0,02 mm et 0,3 mm demeure libre, pour le flux de gaz d'équilibrage thermique, entre l'enveloppe extérieure du rotor RAM (43) et la surface intérieure du stator RAM (41a ; 41b) qui entoure ledit rotor.

9.  Tête de sonde RMN-RAM selon la revendication 7 ou 8, **caractérisée par le fait que** la buse (42b) d'équilibrage de température est disposée de façon telle qu'un flux de gaz d'équilibrage thermique puisse être insufflé le long de l'enveloppe extérieure du rotor RAM (43) selon un angle α ~ 0°, c'est-à-dire parallèlement à l'axe longitudinal dudit rotor RAM (43) à symétrie cylindrique.

10. Tête de sonde RMN-RAM selon l'une des revendications 5 à 9, **caractérisée par le fait que** le rotor RAM (13 ; 33 ; 43) est entouré par une bobine HF (14 ; 34 ; 44) en forme de solénoïde, qui est enroulée sur la surface extérieure d'un tube et est disposée de telle manière que le flux de gaz d'équilibrage thermique puisse être guidé entre ledit rotor et ledit tube.

11. Tête de sonde RMN-RAM selon la revendication 10, **caractérisée par le fait que** le rotor RAM (13 ; 33 ; 43) est entouré, à l'aide de la bobine HF (14 ; 34 ; 44) en forme de solénoïde, à une distance comprise entre 0,02 mm et 0,3 mm par rapport à la paroi intérieure du tube.

12. Tête de sonde RMN-RAM selon l'une des revendications 5 à 11, **caractérisée par** la présence de plusieurs buses (12 ; 32a ; 32b ; 42a ; 42b) d'équilibrage de température offrant, en particulier, des agencements structurels identiques entre eux et disposées, de préférence, symétriquement autour de l'axe longitudinal du rotor RAM (13 ; 33 ; 43) à symétrie cylindrique.

13. Tête de sonde RMN-RAM selon l'une des revendications 5 à 12, **caractérisée par le fait que** la (les) buse(s) (12 ; 32a ; 32b ; 42a ; 42b) d'équilibrage de température est (sont) intégrée(s) dans un palier radial du stator RAM (11 ; 31a; 31b ; 41a; 41b).

14. Tête de sonde RMN-RAM selon l'une des revendications 5 à 11, **caractérisée par le fait que** la (les) buse(s) (32a ; 32b) d'équilibrage de température peu(ven)t être alimentée(s) en gaz d'équilibrage thermique par l'intermédiaire d'un canal distinct.

15. Tête de sonde RMN-RAM selon l'une des revendications 5 à 14, **caractérisée par le fait que** le rotor RAM (13 ; 33 ; 43) consiste en du saphir, en de l'oxyde de zirconium stabilisé en phase tétragonale et/ou en du nitrure de silicium, avec une épaisseur de paroi comprise entre 0,2 mm et 0,7 mm, d'environ 0,55 mm de préférence.

10

14

11    12    13    12'

Fig. 1

20

24

21  23  22'

**Fig. 2**

Fig. 3a

Fig. 3b

Fig. 4a

Fig. 4b

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7915893 B2
- US 5289130 A

**In der Beschreibung aufgeführte Nicht-Patentliteratur**

- **VON D. WILHELM et al.** Fluid flow dynamics in MAS systems. *Journal of Magnetic Resonance,* 2015, vol. 257, 51-63